# EUROPÄISCHE PATENTANMELDUNG

(11) **EP 0 901 918 A2**
(43) Veröffentlichungstag der Anmeldung: **17.03.1999**
(21) Anmeldenummer: 98116744.8
(22) Anmeldetag: 04.09.1998
(51) Int. Cl.: B60J 7/043, B29C 70/76, B29C 44/12, H01L 31/042

(54) **Als Solargenerator ausgebildeter Deckel für Kraftfahrzeug-Schiebedächer**

(30) Priorität: 09.09.1997 DE 19739615
(71) Anmelder: Meritor Automotive GmbH, 60314 Frankfurt (DE)
(72) Erfinder: Malcherczyk, Joseph, 38518 Gifhorn (DE); Walter, Reinhard, 38542 Leiferde (DE); Melzian, Fred, 38486 Kusey (DE); Reimer, Klaus, Dipl.-Ing., 38518 Gifhorn (DE); Gochermann, Hans, Dipl.-Ing., 65488 Holm (DE); Schwarz, Werner, Dipl.-Phys., 63571 Gelnhausen (DE)
(74) Vertreter: Oppermann, Ewald, Dipl.-Ing.

(57) **Zusammenfassung**

Bei einem als Solargenerator ausgebildeten Deckel für Kraftfahrzeug-Schiebedächer mit angeschäumtem Kunststoffrahmen ist ein mit erheblichen Flächenbereichen in den Rahmen hineinreichendes Solarzellenfeld aus kristallinen Solarzellen vorgesehen, wobei durch besondere Maßnahmen sichergestellt ist, daß bei der Umschäumung des Deckels zur Rahmenbildung die bruchempfindlichen kristallinen Solarzellen nicht beschädigt werden. Es kann daher ein flächengroßes Solarzellenfeld untergebracht werden, welches bei leichter Deckelkonstruktion eine hohe Energieausbeute ermöglicht.

## Beschreibung

Die Erfindung bezieht sich auf einen als Solargenerator ausgebildeten Deckel für Kraftfahrzeug-Schiebedächer, entsprechend dem Oberbegriff des Patentanspruchs 1.

Die Bezeichnung "Schiebedächer" wird hier als Sammelbegriff für alle einschlägig bekannten Dachkonstruktionen verstanden, nämlich Schiebedächer mit nur verschiebbarem Deckel, Schiebehebedächer mit sowohl verschiebbarem als auch verschwenkbarem Deckel und Hebedächer mit nur verschwenkbarem Deckel. Auch sogenannte Oberfirstdächer, bei denen der Deckel oberhalb der festen Dachfläche des Kraftfahrzeugs verschiebbar und bei einigen Konstruktionen auch zusätzlich verschwenkbar (Spoilerdach) ist, sollen ebenfalls durch den verwendeten Sammelbegriff erfaßt sein.

Der bekannte Solargenerator (EP 0 221 287 B1), von dem die vorliegende Erfindung mit dem Oberbegriff des Patentanspruchs 1 ausgeht, ist zwar u.a. für die Verwendung als Schiebedach eines Personenkraftwagens unter Wölbungsanpassung an die aerodynamische Form des Fahrzeugs vorgesehen, jedoch ist die Ausbildung des den Solargenerator in die Schiebedachkonstruktion integrierenden Randbereichs des Verbundes nicht beschrieben.

Es ist auch bekannt (DE 37 37 183 A1), einen Solargenerator, der u.a. zur Verwendung als Solargenerator-Schiebedach eines Personenkraftwagens vorgesehen ist, mit einem Kunststoffrahmen nach einem RIM-Verfahren (Reaction-Injection-Moulding-Verfahren) zu versehen, wobei als Kunststoff ein MehrkomponentenPolyurethanelastomer verwendet wird. Hierbei sind die Solarzellen jedoch beiderseits durch eine starre Platte abgedeckt, nämlich von oben durch eine Glasscheibe und von unten ebenfalls durch eine Glasscheibe oder durch ein Metallblech, wodurch der Deckel eine erhebliche Dicke und dementsprechend ein hohes Gewicht erhält, was bei der Ausbildung der Betätigungselemente für den Deckel mit den daraus resultierenden Nachteilen berücksichtigt werden muß.

Entsprechendes gilt für einen bekannten lichtdurchlässigen Deckel mit Solarverbund für Schiebedächer (DE 41 05 389 C1), bei dem der im Außenrandbereich der lichtdurchlässigen Scheibe liegende Teilflächenbereich mit den leistungsstärkeren, aber undurchsichtigen kristallinen Solarzellen und in einem anderen Teilflächenbereich mit leistungsschwächeren, aber durchsichtigen amorphen Solarzellen unterlegt ist. Dieser aus unterschiedlichen Solarzellen zusammengesetzte Solarverbund ist zwischen zwei Glasscheiben eingeschlossen, deren Außenränder von einem Rahmen umgriffen werden, der als Polyurethan-Umschäumung ausgebildet sein kann.

Bei bekannten als Solargenerator ausgebildeten Deckeln, die bereits in Serienautomobile (AUDI A6 und A8) eingebaut werden, wird die innere von dem angeschäumten Kunststoffrahmen umschlossene Fläche des Deckels zur Anordnung von kristallinen Solarzellen benutzt. Da der Kunststoffrahmen aus Festigkeitsgründen und auch wegen der ggf. erforderlichen Unterbringung von Versteifungsprofilen im Rahmen aber verhältnismäßig breite Rahmenteile aufweist, steht nur der innere umrahmte Deckelbereich für die Unterbringung kristalliner Solarzellen zur Verfügung, wodurch die erzielbare Energieausbeute begrenzt ist.

Eigene Versuche der Anmelderin, kristalline Solarzellen bei einer gattungsgemäßen Solargeneratorausbildung, also bei Verwendung eines leichten Solargenerators mit einer unteren Abdeckfolie, auch im Rahmenbereich unterzubringen und in die Umschäumung einzubeziehen, um dadurch eine höhere Energieausbeute zu erzielen, sind bislang fehlgeschlagen. Es ergab sich eine sehr hohe Bruchrate der Solarzellen bei dem Umschäumungsvorgang.

Der Erfindung liegt die Aufgabe zugrunde, einen als Solargenerator ausgebildeten Deckel für Kraftfahrzeug-Schiebedächer der eingangs genannten Art bereitzustellen, der bei geringem Gewicht eine vergleichsweise hohe Energieausbeute ermöglicht.

Die gestellte Aufgabe wird durch die Merkmale des Anspruchs 1 gelöst. Vorteilhafte oder zweckmäßige Weiterbildungen ergeben sich aus den Unteransprüchen und sind nachfolgend ebenfalls beschrieben.

Erfindungsgemäß wird die größtmögliche Deckelfläche, d.h. die größtmögliche freie Außenfläche der Glasscheibe, zur Unterbringung von kristallinen Solarzellen ausgenutzt, wodurch ein in seinen Außenabmessungen von der Deckelgröße vorgegebenes maximal großes Solarzellenfeld untergebracht werden kann, welches eine hohe Energieausbeute ermöglicht. Dabei sind die unterseitig nur mit einer Folie abgedeckten elastisch eingebetteten Solarzellen im Außenrandbereich des Solarzellenfeides in die Randumschäumung mit einbezogen, wobei ein gegenüber üblichen RIM-Umschäumungen vergleichsweise geringer Schäumdruck, der gemäß Anspruch 2 < 1 bar ist, und die diesen Druck begleitende vergleichsweise geringere Temperatur die Bruch- und Beschädigungsgefahr für die empfindlichen dünnen kristallinen Solarzellen sehr weitgehend beseitigen. Hierzu trägt auch bei, daß der geringe Druck den Einsatz weicher Dichtungen für die Begrenzung des Schäumbereichs in der Umschäumungsform bei direkter Anlage an die Abdeckfolie und dementsprechend auch geringe Formschließkräfte ermöglicht.

Zur Vermeidung einer Druckbelastung der Solarzellen durch in den Rahmen eingeschäumte starre Profilstäbe ist gemäß Anspruch 3 vorgesehen, die Profilstäbe gegenüber dem Verbund auf Abstand zu halten.

Zu diesem Zweck können entsprechend Anspruch 4 zwischen den Profilstäben und dem Verbund Abstandshalter aus weichem Material eingelegt sein, welche zwischen den Profilstäben und dem Verbund während aller Phasen der Rahmenformung einen ausreichenden Abstand ermöglichen, jedoch selbst keine zerstörende Pressung der Solarzellen hervorrufen. Die Abstandshalter werden bei der Umschäumung eingeschlossen und verbleiben daher im Schaummaterial des Rahmens.

Alternativ kann gemäß Anspruch 5 die Anordnung auch so getroffen sein, daß nach dem Umschäumen aus dem Rahmen vorstehende Laschen gegenüberliegender seitlicher Profilstäbe, die beim Einbau des Deckels in das Schiebedach dem Angriff von Funktionsteilen der Deckelbetatigungseinrichtung dienen, als Elemente zur Abstandshaltung zwischen diesen Profilstäben und dem Verbund während der Rahmenformung herangezogen werden. Hierbei liegen die beiden anderen Profilstäbe den über die Flansche abgestützten seitlichen Profilstäben unmittelbar auf, wodurch auch zwischen den aufliegenden Profilstäben und dem Verbund Abstände vorhanden sind. Auch bei dieser Ausgestaltung der den beschriebenen Abstand herbeiführenden Elemente erfolgt auf den Verbund und damit auf die empfindlichen Solarzellen keine Pressung durch Profilstäbe, ohne daß zu diesem Zweck gesonderte Abstandshalter im Rahmen selbst angeordnet werden müssen.

Die Erfindung wird nachfolgend anhand der Ausführungsbeispiele darstellenden Zeichnungen näher erläutert. Darin zeigt:
- Fig. 1: die Draufsicht auf einen als Solargenerator ausgebildeten Deckel für Kraftfahrzeug-Schiebedächer in einer ersten Ausführungsform,
- Fig. 2: einen abgebrochenen Schnitt durch den Deckel entlang der Linie II-II in Fig. 1,
- Fig. 3: einen abgebrochenen Schnitt durch den Deckel entlang der Linie III-III in Fig. 1,
- Fig. 4: einen der Fig. 2 entsprechenden abgebrochenen Schnitt durch den Deckel und zusätzlich durch das Formwerkzeug zum Anschäumen des Rahmens an den Deckel,
- Fig. 5: die Draufsicht auf einen weiteren als Solargenerator ausgebildeten Deckel für Kraftfahrzeugschiebedächer in einer zweiten Ausführungsform und
- Fig. 6: einen abgebrochenen Schnitt durch den Deckel und zusätzlich durch das Formwerkzeugunterteil zum Anschäumen des Rahmens an den Deckel entlang der Linie VI-VI in Fig. 5.

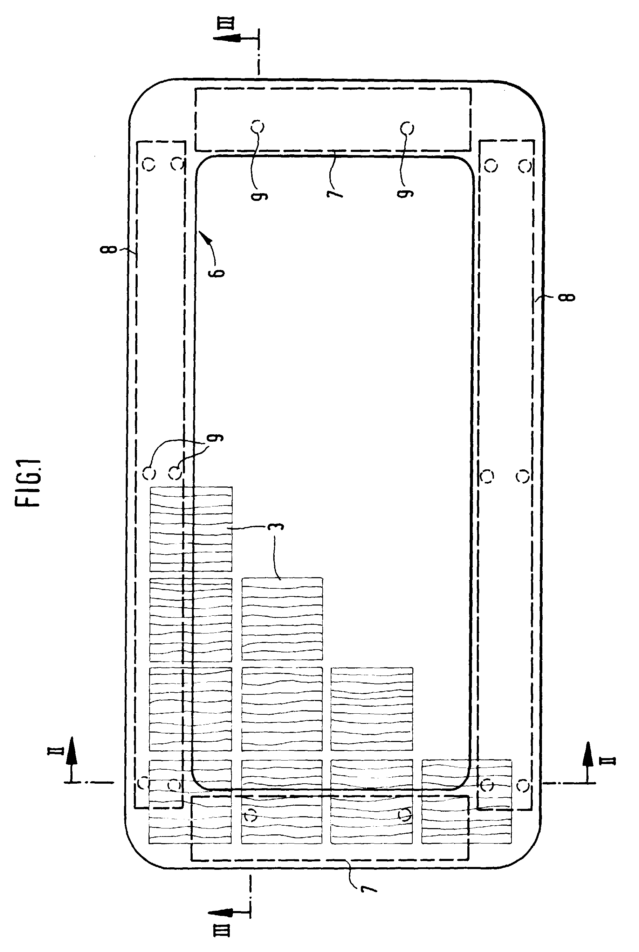

Die in den beiden Ausführungsformen dargestellten Deckel unterscheiden sich lediglich in der Ausbildung der den Rahmen verstärkenden Profilstäbe und deren Abstandshaltung zum Verbund, so daß zunächst der Deckelaufbau für beide Ausführungsformen anhand der Fig. 1 bis 3 nachfolgend beschrieben wird.

Die Glasscheibe 1 trägt auf ihrer Unterfläche die in ein elastisches Kunststoffmaterial 2 eingebetteten kristallinen Solarzellen 3. Das elastische Kunststoffmaterial 2 besteht ursprünglich aus zwei getrennten Schmelzkleberfolien aus beispielsweise EVA (Ethylen-Vinyl-Acetat-Copolymer), zwischen welche die Solarzellen eingelegt werden. Nach einer Temperatur/Vakuum-Behandlung verschmelzen die beiden Folien zu einer Einbettungsschicht aus dem elastischen Kunststoffmaterial 2, die an der Unterfläche der Glasscheibe 1 fest haftet und nach unten von der Abdeckfolie 4 abgedeckt ist.

Die Glasscheibe 1, das elastische Kunststoffmaterial 2 mit den darin eingebetteten Solarzellen 3 und die Abdeckfolie bilden nach ihrer Vereinigung einen einteiligen Verbund 5, der in dieser Gestalt gelagert, transportiert und schließlich zur Herstellung des als Solargenerator ausgebildeten Deckels für Kraftfahrzeug-Schiebedächer mit einer noch zu beschreibenden Rahmung versehen werden kann.

Die kristallinen Solarzellen 3, die bei einer Dicke von nur etwa 0,1 bis 0,3 mm sehr bruchempfindlich sind, können beispielsweise jeweils Flächenabmessungen von etwa 100 x 100 mm aufweisen. Die einzelnen Zellen sind elektrisch miteinander verbunden und besitzen eine gemeinsame Anschlußbuchse (nicht dargestellt), die zweckmäßig in dem noch zu beschreibenden Rahmen des Deckels untergebracht ist.

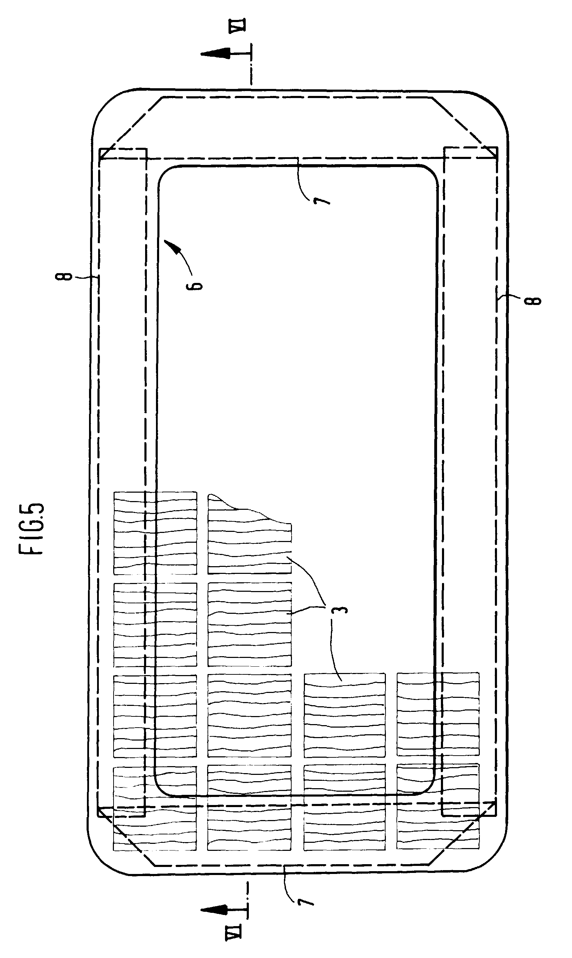

Die Solarzellen 3 bilden mit gegenseitigen Abständen von etwa 2 bis 5 mm in regelmäßiger Reihenanordnung ein geschlossenes Solarzellenfeld, wie das in den Fig. 1 und 5 dargestellt ist, in welchen nur einige der Solarzellen des Solarzellenfeldes eingezeichnet sind. Wie die Zeichnungen ebenfalls verdeutlichen, ist das Solarzellenfeld in seinen Außenabmessungen nur wenig kleiner als die freie Außenfläche der Glasscheibe 1, so daß die Außenfläche der Glasscheibe 1 sehr weitgehend mit Solarzellen 3 unterlegt ist, wodurch eine hohe Energieausbeute erzielbar ist.

Der Deckel besitzt einen Rahmen 6, der aus einem Kunststoff auf Polyurethanbasis besteht, der an den Deckel angespritzt bzw. angeschäumt ist. Wie aus den Fig. 1 bis 3 ersichtlich ist, überdeckt der angeschäumte Rahmen 6 erhebliche Flächen des Außenrandbereichs des Solarzellenfeldes von unten. Dieses ist ohne Beschädigung oder Zerstörung der betreffenden Flächenbereiche des Solarzellenfeldes nur möglich, wenn beim Anspritz- und Umschäumungsvorgang die im Polyurethankunststoff auftretenden Drücke sehr niedrig sind.

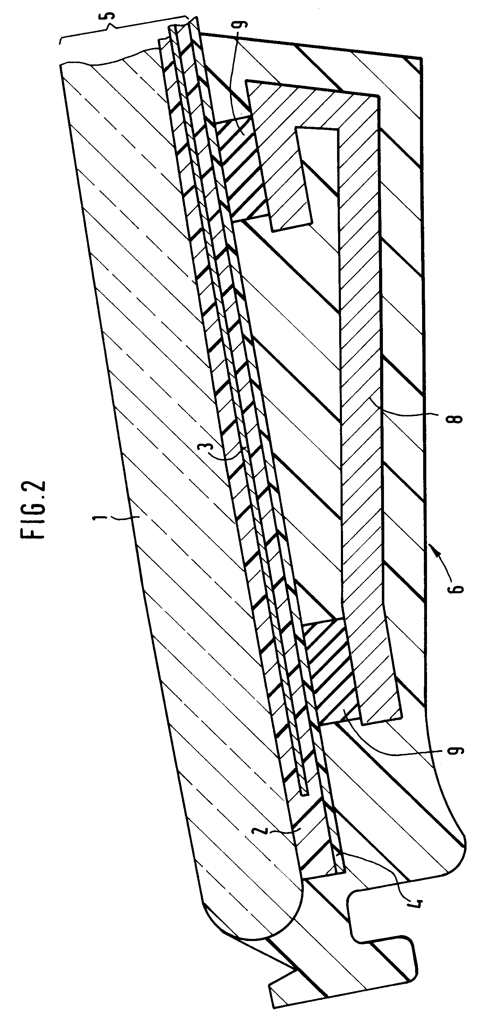

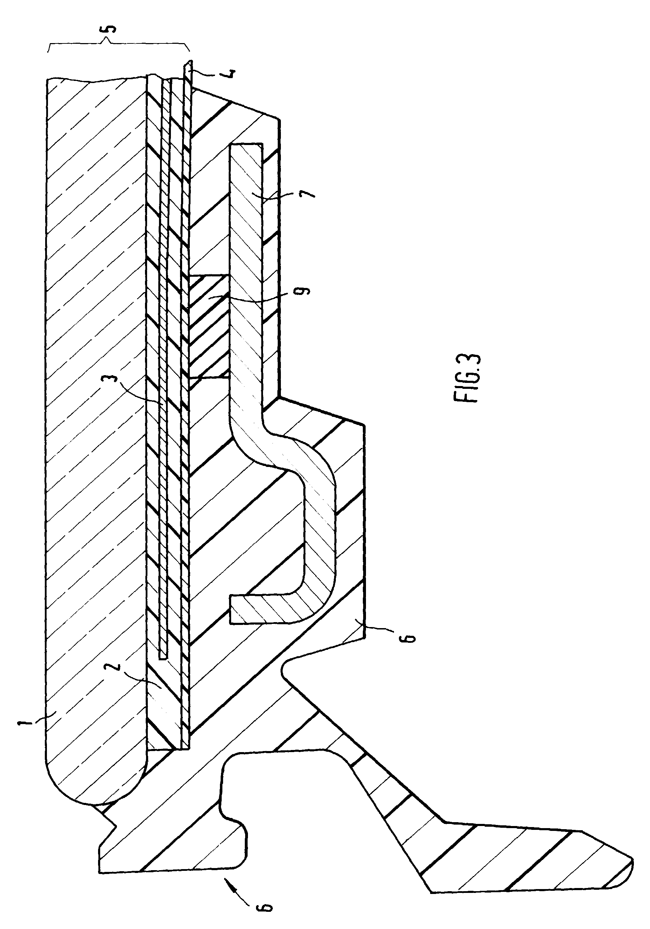

Wie aus den Fig. 2 und 3 hervorgeht, wird der Rahmen 6 nur an die Unterseite des Deckels und an die Außenkante der Glasscheibe 1 angeschäumt, so daß praktisch die volle Außenfläche der Glasscheibe 1 nach oben freiliegt. Am Außenrand des Rahmens 6 befindet sich eine in üblicher Weise ausgestaltete hinterschnittene Aufnahmeprofilierung für eine Randspaltabdichtung (nicht dargestellt) des Schiebedachs. Wie bei derartigen angeschäumten Rahmen üblich, sind die vier Rahmenteile durch eingeschäumte starre paarweise übereinstimmende Profilstäbe 7 und 8 verstärkt. Wegen der Bruchempfindlichkeit der Solarzellen, die auch im Verbund 5 noch gegeben ist, werden besondere Maßnahmen getroffen, die eine zerstörende Druckeinwirkung der Profilstäbe 7 und 8 auf den Verbund 5 verhindern. Diese Maßnahmen bestehen darin, daß die Profilstäbe 7 und 8 schon während der Anbringung des Rahmens und selbstverständlich auch im fertigen Deckel zu dem Verbund 5 auf Abstand gehalten sind.

Bei der aus den Fig. 1 bis 4 ersichtlichen Ausführungsform geschieht dies durch Zwischenlage von Abstandshaltern 9 aus weichem Material, beispielsweise aus Moosgummi oder weichem Polyurethan zwischen die zueinander gekehrten Flächen des Verbundes 5 und der Profilstäbe 7 und 8. Die Abstandshalter 9 liegen der Abdeckfolie 4 von unten an und sind mit den Profilstäben 7 und 8 zweckmäßig durch Kleben verbunden.

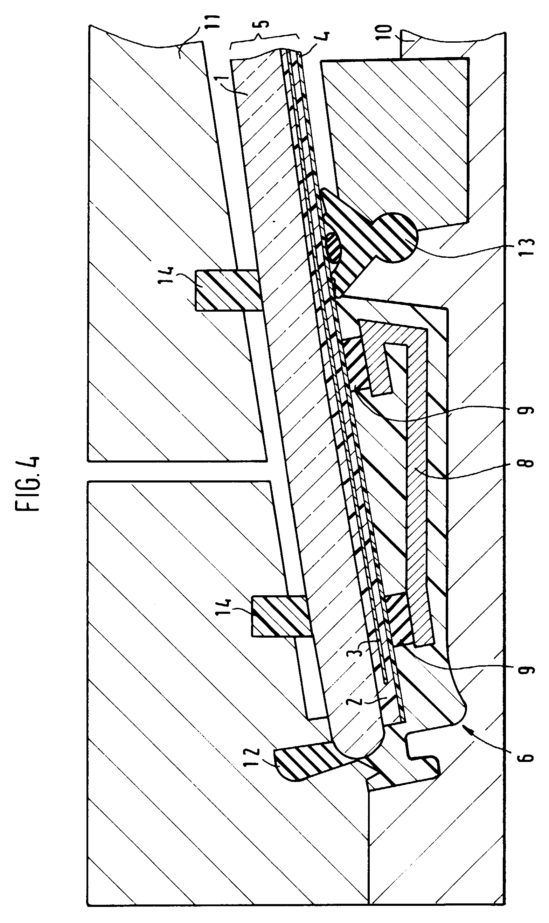

In Fig. 4 sind die aus einem Unterteil 10 und einem Oberteil 11 bestehenden Formwerkzeuge für die Anschäumung des Rahmens 6 in geschlossenem Zustand dargestellt. Da der Schäumdruck in der Form niedrig ist, können die zur Begrenzung des Schäumbereichs verwendeten Dichtungen 12 und 13 ebenfalls aus einem weichen Material, beispielsweise Moosgummi, ausgeführt sein. Außerdem sind aufgrund des geringen Schäumdrucks auch nur geringe Formschließkräfte erforderlich, so daß von den Dichtungen 12 und 13 sowie von Andruckleisten 14 im Oberteil 11 der Formwerkzeuge nur geringe Kräfte auf den Deckel übertragen werden, die eine Beschädigung der empfindlichen Solarzellen ausschließen. Die besonders strukturierte Dichtung 13 ist im gezeigten Beispiel zweiteilig ausgebildet und besteht aus einem größeren Dichtkörper, in dessen obere Nut eine im unverformten Zustand im Querschnitt kreisrunde Schaumdichtung eingelegt ist. Der größere Dichtungskörper kann eine Shore-A-Härte von 40 bis 50 und die Schaumdichtung eine solche von etwa 30 aufweisen.

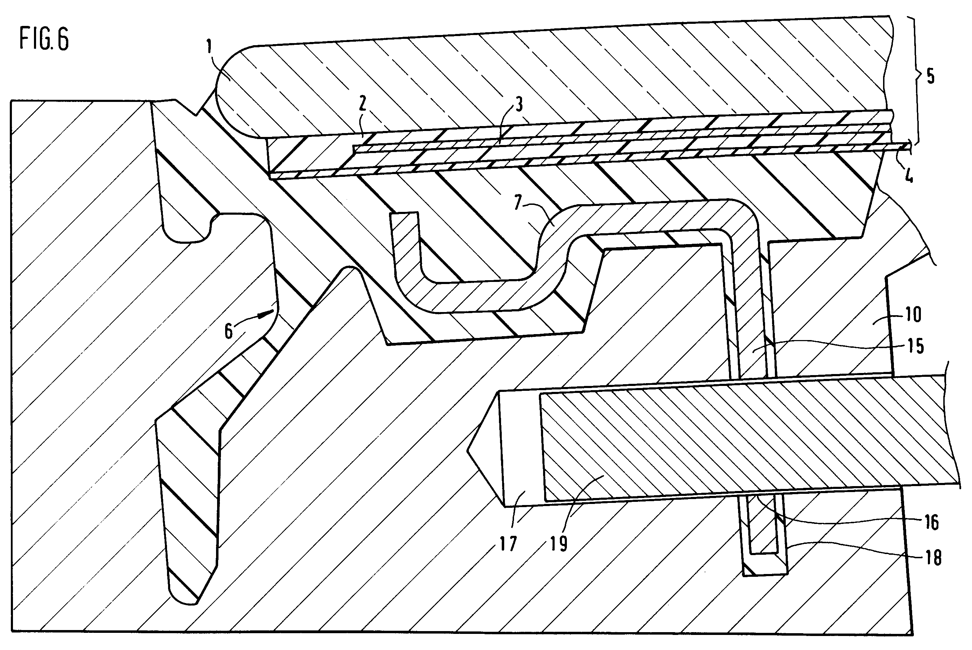

Zur Erläuterung der zweiten Ausführungsform des Deckels, d.h. der Elemente, die den erforderlichen Abstand zwischen den Profilstäben und dem Verbund sicherstellen, wird nunmehr auf die Fig. 5 und 6 Bezug genommen. Fig. 6 zeigt die Situation an einer Seite des Deckels, der auch bezüglich des Formwerkzeugs an der anderen Seite spiegelbildlich ausgeführt ist. Wie Fig. 6 verdeutlicht, besitzen die seitlichen Profilstäbe nach unten gerichtete Laschen 15, die aus dem fertigen Rahmen 6 nach unten vorstehen. Diese Laschen besitzen Aufnahmebohrungen 16 für bei der Deckelmontage anzubringende Schraubbolzen u.dgl. Diese in den Profilstäben 7 bei ihrer Einlegung in die Form schon vorhandenen Bohrungen werden zur Erzielung der beschriebenen Abstandshaltung zwischen den Profilstäben 7 und dem Verbund 5 herangezogen. Zu diesem Zweck sind im Unterteil 10 der Formwerkzeuge Bohrungen 17 angebracht, die mit jeweils einer Aufnahmebohrung 16 konzentrisch fluchten. Die Laschen 15 finden in entsprechenden Formausnehmungen 18 Aufnahme. Die Bohrungen 17 sind quer durch die Formausnehmungen 18 hindurchgeführt. In jede Bohrung 17 wird nach Einlegung der Profilstäbe 7 ein Steckbolzen 19 eingeführt, der dabei auch die Aufnahmebohrung 16 in der Lasche 15 durchsetzt, wodurch über die Lasche 15 der Profilstab 7 in dem erforderlichen Abstand zum Verbund 5 gehalten wird. Nach der Formung des Rahmens werden die Steckbolzen 19 entfernt, so daß eine Endformung des Deckels aus dem Unterteil 10 der Formwerkzeuge möglich ist.

Bei der Ausführungsform der Abstandshaltung gemäß den Fig. 5 und 6 ist weiterhin vorgesehen, daß die Profilstäbe 7 und 8 sich vorn und hinten mit ihren Enden überlappen, so daß die vorn und hinten am Deckel befindlichen Profilstäbe 8 von den seitlichen Profilstäben 7 gestützt und damit ebenfalls auf Abstand zu dem Verbund 5 gehalten werden.

Zusammenfassend ermöglicht die Erfindung einen als Solargenerator ausgebildeten Deckel für Kraftfahrzeug-Schiebedächer mit angeschäumtem Kunststoffrahmen, bei welchem ein mit erheblichen Flächenbereichen in den Rahmen hineinreichendes Solarzellenfeld vorgesehen ist. Hierbei wird durch besondere Maßnahmen sichergestellt, daß bei der Umschäumung des Deckels zur Rahmenbildung die bruchempfindlichen kristallinen Solarzellen nicht beschädigt werden. Es kann daher ein flächengroßes Solarzellenfeld untergebracht werden, welches bei leichter Deckelkonstruktion eine hohe Energieausbeute ermöglicht.

Sehr wesentlich ist hierbei, daß der Rahmen mit einem vergleichsweise niedrigen Schäumdruck angeschäumt ist. Während bei herkömmlichen RIM-Deckelumschäumungen hohe Schäumdrücke über 10 bar, üblicherweise 12 bar (Hochdruckverfahren), zur Anwendung gelangen, sind Rahmen gemäß der Erfindung mit sehr niedrigen Drücken angeschäumt (Niederdruckverfahren). Rahmen, die mit einem Druck < 1 bar angeschäumt sind, weisen nur eine vernachlässigbar kleine Bruchrate der Solarzellen auf. Der Rahmen kann mit ausgezeichneten Ergebnissen mit einem so niedrigen Druck wie etwa 0,2 bar angeschäumt sein.

## Patentansprüche

1. Als Solargenerator ausgebildeter Deckel für Kraftfahrzeug-Schiebedächer, mit einer Glasscheibe (1) und einem aus einer Mehrzahl von kristallinen elektrisch miteinander verbundenen Solarzellen (3) bestehenden unterhalb der Glasscheibe (1) angeordneten Solarzellenfeld, das zwischen der Glasscheibe (1) und einer unteren Abdeckfolie (4) in einem elastischen Kunststoffmaterial (2) unter Bildung eines die Glasscheibe (1), die Solarzellen (3), das elastische Kunststoffmaterial (2) und die Abdeckfolie (4) umfassenden Verbundes (5) eingebettet ist, **dadurch gekennzeichnet**, daß das Solarzellenfeld in seinen Außenabmessungen nur wenig kleiner ist als die freie Außenfläche der Glasscheibe (1), wobei an den Deckel ein Rahmen (6) aus einem Kunststoff auf Polyurethanbasis angeschäumt ist, welcher die Außenrandbereiche des Solarzellenfeldes von unten überdeckt, und wobei der Rahmen (6) mit einem niedrigen Schäumdruck angeschäumt ist.

2. Deckel nach Anspruch 1, **dadurch gekennzeichnet**, daß der Rahmen (6) mit einem Druck < 1 bar angeschäumt ist.

3. Deckel nach Anspruch 1 oder 2, **dadurch gekennzeichnet**, daß in den Rahmen (6) eingeschäumte, diesen verstärkende starre Profilstäbe (7, 8) zu dem Verbund (5) auf Abstand gehalten sind.

4. Deckel nach Anspruch 3, **dadurch gekennzeichnet**, daß zwischen den Profilstäben (7, 8) und dem Verbund (5) Abstandshalter (9) aus weichem Material eingelegt sind.

5. Deckel nach Anspruch 3, **dadurch gekennzeichnet**, daß die beiden seitlichen Profilstäbe (7) mit nach unten gerichteten Laschen (15) aus dem Rahmen (6) vorstehen und die seitlichen Profilstäbe (7) mittels der Laschen (15) zu dem Verbund (5) beim Umschäumen auf Abstand gehalten sind, wobei die anderen Profilstäbe (8) vorn und hinten mit ihren Enden den benachbarten Enden der seitlichen Profilstäbe (7) aufliegen.
